Europäisches Patentamt

European Patent Office

Office européen des brevets

(19)

(11)　EP 1 420 518 A2

(12)　## EUROPEAN PATENT APPLICATION

(43) Date of publication:
　　**19.05.2004　Bulletin 2004/21**

(51) Int Cl.7: **H03M 13/23**, H03M 13/27,
　　　**H03M 13/29**

(21) Application number: **04000755.1**

(22) Date of filing: **02.04.1998**

(84) Designated Contracting States:
　　**DE FR GB IT NL**

(62) Document number(s) of the earlier application(s) in
　　accordance with Art. 76 EPC:
　　**98913965.4 / 0 986 922**

(71) Applicant: **Inmarsat Ltd.**
　　**London EC1Y 1AX (GB)**

(72) Inventors:
　　• **Jones, Edward Arthur**
　　　**Maldon Essex CM9 6RZ (GB)**

　• **Fines, Panagiotis**
　　**London EC1Y 0SU (GB)**

(74) Representative:
　　**Cross, James Peter Archibald et al**
　　**R.G.C. Jenkins & Co.,**
　　**26 Caxton Street**
　　**London SW1H 0RJ (GB)**

Remarks:
　　This application was filed on 15 - 01 - 2004 as a
　　divisional application to the application mentioned
　　under INID code 62.

(54)　**Convolutional encoder with interleaving**

(57)　A radio frequency paging service has one or more TDMA return channels (R) in which terminals (14) acknowledge receipt of messages having an acknowledge flag set. In one alternative, slots are allocated in the return channel (R) by a slot allocation field in the respective messages. In another alternative, each terminal (14) monitors the messages addressed to other terminals (14) to determine which of them require a response, and determines, from the order of a message addressed to itself among the messages requiring a response, which slot to use for acknowledgement. The TDMA return channels (R) include unreserved slots which terminals (14) access on a contention basis. The frequencies of transmissions in the slots are randomized within a predefined limit to reduce the probability of interference between different terminals (14) in the same unreserved slot. The predefined limit is based on the maximum differential Doppler shift between terminals (14). The return channels (R) are allocated as a continuous block of frequency channels, thereby reducing signalling overhead when allocating these channels, and allowing the block of channels to be decoded by a single DSP.

Data bursts transmitted by the terminals (14) in the return channels (R) are half-rate convolutionally encoded and interleaved so that the transmitted bit sequence contains alternating bits from the two outputs of the half-rate encoder.

Each terminal (14) is identified by a forward identity code in received messages and by a return identity code in transmitted messages, the identity codes being relat-

ed by a predetermined algorithm.

Fig. 9

EP 1 420 518 A2

**Description**

Technical Field

The present invention relates to a method and apparatus for implementing a radio frequency messaging or paging system with acknowledgement capability.

Background Art

One example of a paging system without acknowledgement capability is the Inmarsat-D™ satellite messaging system. This system was launched in December 1996 and was outlined in information sheets and articles issued by the International Mobile Satellite Organization from 1995 onwards, such as "Inmarsat-D - The Small Revolution in Satellite Communications", the Inmarsat-D Fact Sheet, and the article "Truly Global Personal Messaging - the mobile satcomms solution", by Bashir A. Patel, Inmarsat. Specific aspects of the Inmarsat™ messaging system are described in GB patent application no. 9625256.4.

European patent publication EP 0 505 489 A describes a satellite-based acknowledge-back paging system in which a pager acknowledges all messages which it receives by transmitting an acknowledge code to the satellite network. However, this would give rise to almost as many acknowledgements as original paging messages; it is not disclosed how bandwidth is to be allocated to these acknowledgements and how interference between acknowledgements is to be avoided.

International patent publication no. WO 94/13093 describes a terrestrial paging system in which paging receivers acknowledge receipt of messages if the messages are flagged as requiring acknowledgement. The acknowledgement signals are transmitted back to the paging system via a radio telephone system, such as a CT-2 cordless telephone system connected to a PSTN. With this arrangement, the acknowledgement signals do not take up any bandwidth in the paging system, but a separate radio telephone system is required.

A further problem associated with low-bandwidth satellite communications is the frequency channel spacing required to avoid interference caused by differential Doppler shift, relative to the bandwidth required to carry the low-bandwidth signals. The orbits of geostationary satellites are generally inclined by a few degrees relative to the equator, since to maintain a precisely geostationary orbit at all times would increase the amount of fuel required for station-keeping and so reduce the lifetime of the satellite. Inmarsat™ satellites are typically launched into an orbit of +3° inclination and the orbit is allowed to drift to -3° inclination before the satellite is manoeuvred back to its original orbit. The result of this inclination is that the satellites exhibit a sinusoidal North-South motion relative to the Earth's surface, which causes a Doppler shift in signals transmitted to and from the satellite, dependent on the direction of a terminal from the satellite. In the Inmarsat-D™ system, the signals occupy less than 1 kHz of bandwidth, but a channel bandwidth of 2.5 kHz is required to avoid interference due to differential Doppler. With non-geostationary satellites, the relative motion along the satellite-terminal axis, and therefore the relative Doppler, may be much higher.

In radio frequency communication systems which are susceptible to burst errors and fading, data may be forward error correction (FEC) encoded and interleaved before transmission so as to spread the effect of a burst error over a code word and to increase the chance of correcting all of the bit errors. Any improvement in the encoding and interleaving techniques which can reduce the bit error rate without reducing the coding rate or increasing the bandwidth of the radio frequency channel would be highly desirable.

In paging systems with acknowledgement functions, the paging system must identify the pager to which a message is addressed and the pager must identify itself to the paging system when submitting an acknowledgement. However, eavesdroppers may match the forward and return identifying codes in order to determine which messages are being exchanged with a specific terminal.

Statement of the Invention

According to one aspect of the present invention, there is provided a method and apparatus for allocating return channels for acknowledgement of paging messages, in which the pagers which receive messages requiring acknowledgement determine which return channel to use by detecting which other messages addressed to other terminals require acknowledgement and selecting a return channel according to a common allocation algorithm which is applied by the other terminals to determine their own return channels without collision.

An advantage of this aspect is that the allocation of return channels does not need to be indicated explicitly by the paging system. Instead, the pagers select a return channel according to which other return channels are to be used.

According to another aspect of the present invention, there is provided a method and apparatus for allocating return channels for acknowledgement of paging messages, comprising determining which of said paging messages require a response, allocating a return channel for each said response, and transmitting said messages in a frequency channel together with allocation information indicating the return channels to be used for acknowledging those of the paging messages which require acknowledgement.

An advantage of this aspect of the present invention is that individual pagers can determine which return channel to use for acknowledgement without having to decode paging messages addressed to other pagers.

According to another aspect of the present invention, there is provided a radio frequency transmission method and apparatus in which different transmitters are assigned the same frequency channel, but transmit at frequencies randomly offset from the nominal frequency of the frequency channel.

An advantage of this aspect is that the transmitters may transmit with overlapping timings, with a reduced risk of interference due to the random separation of the transmission frequencies.

According to another aspect of the present invention, there is provided a method and apparatus for assigning multiple frequency channels to a set of transceivers, in which the channels are assigned in a successive frequency block.

An advantage of this aspect is that only one of the frequency channels need be explicitly indicated to the transceivers, together with a number indicating the number of additional channels in the block, thus reducing signalling overhead. Moreover, the block of successive frequency channels can be down-converted by a single synthesizer and decoded by a single DSP using digital demodulation techniques, instead of demodulating each channel independently.

Preferably, said terminals uses a common frequency reference for their transmissions in the channels. This allows a narrow channel spacing since the frequency uncertainty between the different terminals is reduced.

According to another aspect of the present invention, there is provided an encoding and interleaving method and apparatus in which a convolutional encoder outputs two parallel encoded bitstreams which are read into an interleaver, and read out of the interleaver in an order which comprises sequences of alternating bits from the two encoded bitstreams.

Brief Description of the Drawings

Specific embodiments of the present invention will now be described with reference to the accompanying drawings, in which:

Figure 1 is a schematic diagram of a satellite messaging system in an embodiment of the present invention;
Figure 2 is a schematic diagram showing bulletin board and traffic channels transmitted from the earth station to the message terminal of Figure 1;
Figure 3 shows the functions of the earth station which relate to the forward link;
Figure 4 shows the functions of the earth station which relate to the return link;
Figure 5 shows the functions of the message terminal in greater detail;
Figure 6 shows the structure of a frame of one of the traffic channels;
Figure 7 shows the structure of a frame of the bulletin board channel;
Figure 8 shows the structure of a frame of one of the return channels; and
Figure 9 shows a convolutional encoder used to encode data bursts in the return channel.

Modes for Carrying Out the Invention

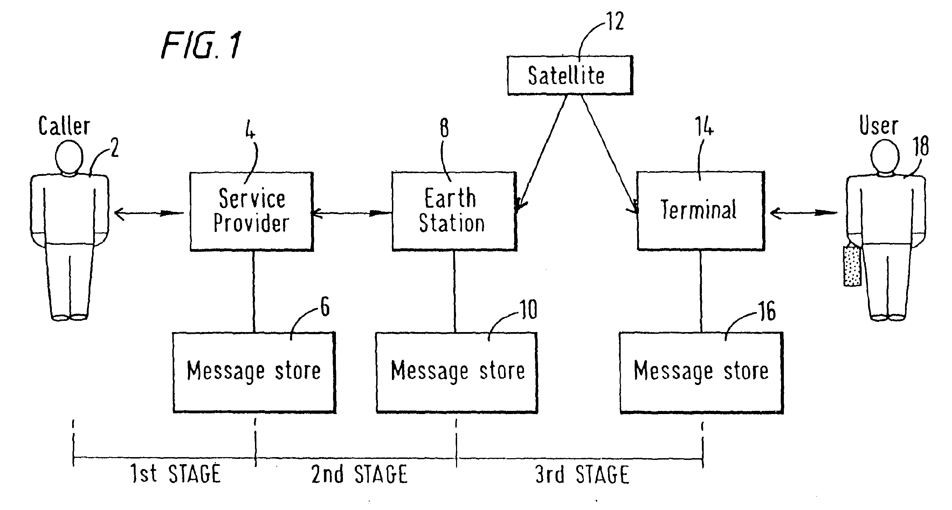

Figure 1 shows the structure of a satellite based store and forward messaging system, in which messages are sent from a caller 2 to a selected user 18. The messages are initially sent to a service provider 4, which routes the message to the appropriate earth station 8. The service area of the messaging system is covered by a plurality of satellites 12, such as the Inmarsat-3™ satellites which are geostationary repeater satellites which relay data from earth stations to a selected area of the earth's surface covered by one of the spot beams generated by the satellite antennas. Each satellite 12 is able to receive and relay signals from more than one earth station located within its field of view. Messages are transmitted from the earth station 8 to the satellite 12, which relays the messages down to a selected area. If a message terminal 14 is within that area, it receives the messages and decodes those messages which carry its identity code. The decoded messages are displayed to the user 18. If the messages carry an indication that acknowledgement is required, the message terminal sends an acknowledgement signal via the satellite 12 to the earth station 8.

The messages are sent by means of a three-stage process, as explained below.

Caller to Service Provider

The caller 2 sends a message to the service provider 4, for example by telephoning an operator and dictating the message, or by encoding the message and sending it over a network, for example by means of a modem connected to a PSTN. The message may comprise an alphanumeric or numeric string, a simple alert code, or binary data, which is passed transparently from the caller 2 to the user 18. Additionally, the caller specifies the identity of the user 18 and optionally the user's approximate location.

The service provider 4 consists of a facility which allows reception of messages from callers, storage of the messages in a service provider store 6 and routing of the messages; the service provider 4 is analogous in this way to service providers in terrestrial paging systems.

Service Provider To Earth Station

The service provider 4 formats the message and the user identity to generate a paging request message. The service provider 4 routes the paging request message to the earth station 8 which serves the satellite 12 which covers the region in which the user 18 is expected to be. This region may be indicated by the caller 2 or may be determined from a location register stored at the service provider, which is updated by the user 18 calling the service provider 4. The paging request message may be routed to more than one earth station serving more than one satellite if there is uncertainty as to the location of the user 18.

Earth Station to Message Terminal

The earth station 8 receives the paging request message and stores it in an earth station store 10, which buffers messages prior to transmission over the satellite 12. The paging request message is converted to a format for transmission and transmitted to the satellite 12, which retransmits the message over one of the spot beams selected by the earth station 8.

If the message terminal 14 is switched on, is tuned to the correct traffic channel and is within the coverage area of the selected spot beam, it detects that an address portion of the message matches an identity code assigned to the message terminal and decodes the message following this address portion. The decoded message is stored in a message terminal store 16 and is displayed to the user 18.

Acknowledgement

As an optional fourth stage, the terminal 14 detects whether an acknowledge flag in a control field of the received message is set. If so, the terminal transmits a short acknowledgement signal in a return channel via the satellite 12 to the earth station 8. The acknowledgement signal contains a code identifying the message terminal 14 and optionally a short burst of user data.

Channel Types

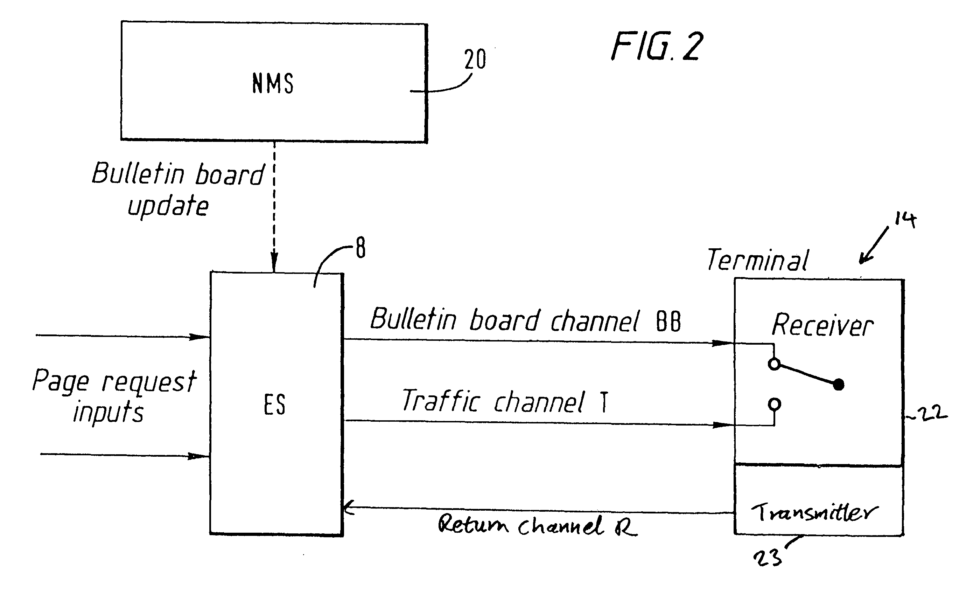

As shown in Figure 2, each earth station 8 transmits at least one traffic channel T which carries paging messages. Multiple earth stations may transmit via the same satellite 8. In addition, for each satellite 12 one earth station 8 broadcasts a bulletin board channel BB. The bulletin board channel is broadcast on a fixed frequency on a global beam which has a coverage area substantially encompassing the coverage areas of all the spot beams of the satellite 12. When the terminal 14 is switched on, it initially tunes to the bulletin board channel BB, which carries all the information needed by the terminal to retune to the frequency of the traffic channel T on which it can expect messages to be transmitted.

Network information concerning the traffic channel frequency allocations is submitted from a network management system 20, which determines which frequencies are assigned to each earth station 8. The information is used to generate the bulletin board channel information which is transmitted in the bulletin board channel BB. A receiver 22 in the terminal 14 is selectively tunable to either the bulletin board channel frequency or any designated one of a set of traffic channel frequencies.

The terminal 14 further includes a transmitter 23 which transmits acknowledgement signals on a return channel R to the earth station 8.

Earth Station - Forward Link

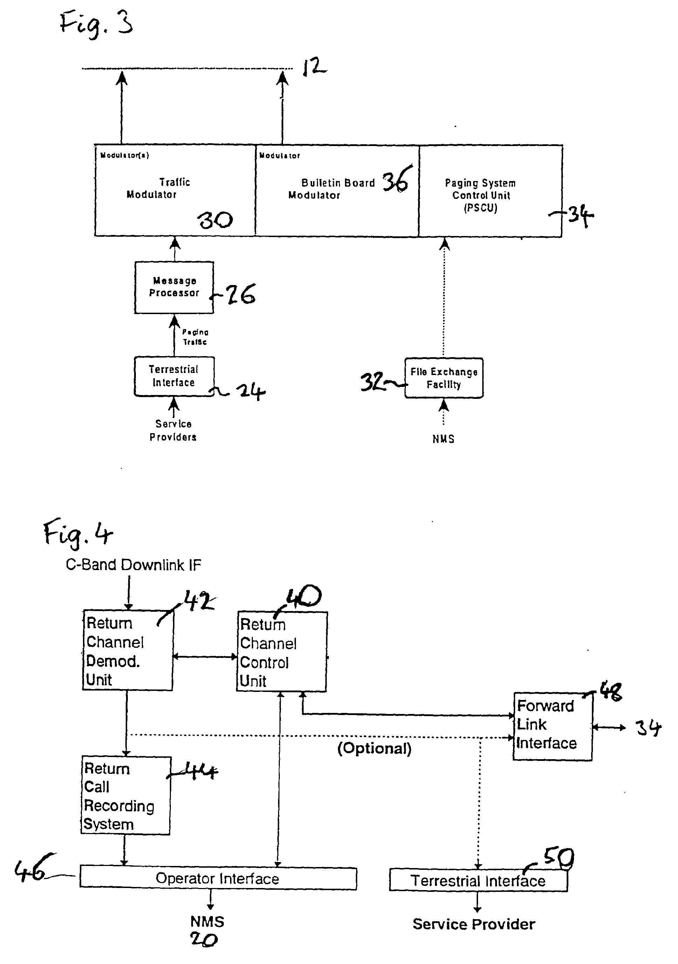

Figure 3 shows the functional portions of the earth station 8 which are concerned with forward transmission of messages. A terrestrial interface 24 is adapted to receive paging request signals sent from the service provider over a network, such as an ISDN. The paging request signals are sent to a message processor 26 which buffers the messages and formats them for transmission. After formatting, the data is passed to a traffic modulator where the data is modulated to an intermediate frequency corresponding to the intended traffic channel. All intermediate frequencies are then up-converted to C-band and transmitted to the satellite 12.

A bulletin board modulator 36 receives the current bulletin board information from the NMS 20 and modulates and transmits this information at C-band if the earth station 8 is designated as the bulletin board transmitter.

The current bulletin board information and traffic channel assignments are received from the NMS 20 via a file exchange facility 32, which may be a floppy disk drive or modem connection. Paging control files input at the file exchange facility are stored at a paging system control unit 34 and the relevant information contained therein is distributed to the traffic and bulletin board modulators 30, 36 so as to control the frequencies at which the channels are transmitted and to provide the bulletin board information in the correct format. The paging system control unit 34 also includes a clock referenced to Universal Time, and controls the timing of transmission of the traffic and bulletin board channels with reference to this clock.

Earth Station - Return Link

Functional features of the earth station 8 which receive and process the return channel R are shown in Figure 4. These features are not necessarily implemented separately from those of Figure 3, and may in fact share common hardware, but are shown separately for clarity.

A return link controller 40 provides overall control of the return link system and coordination with the forward link system by means of a forward link interface 48 connected to the paging system controller 34. A return channel demodulator 42 is provided with control and timing information by the return link controller 40 and receives and demodulates return channel transmissions from the terminals 14 via the satellite 12. Those transmissions which can be correctly demodulated and decoded are passed to a return call recorder which logs details of each transmission, such as the time of receipt and the identity of the transmitting terminal, and provides this information to an operator interface 46, such as a drive for a recordable non-volatile medium or a modem, which allows the information to be passed to the NMS 20. This information may be used for accounting purposes.

Optionally, as shown by dotted lines in Figure 4, the decoded return transmissions are output to the forward link interface 48. This allows the paging system controller 34 to verify that a particular message has been received. This information may be passed on to the service provider 4 and thence to the caller 2. Alternatively, or additionally, the paging system controller retransmits any paging messages that require acknowledgement, are addressed to a terminal which has acknowledgement capability, but have not been acknowledged within a specified time.

As a further option, the return transmissions are output to a terrestrial interface 50 connected to the service provider 4, which routes them to a terrestrial user. In this way, short messages may be sent over the return link to terrestrial users.

Satellite

The satellite 12 receives forward link signals transmitted by the earth station 8 at C-band and translates each received frequency channel to a corresponding transmitted frequency channel at L-band without affecting the signal content; the satellite acts as a transparent repeater. Different groups of received frequency channels are mapped onto different transmitted spot beams and one or more of the received frequency channels are mapped onto the global beam. Likewise, the satellite receives return link signals transmitted by the terminals 14 in frequency channels at L-band and translates them to C-band for reception by the earth station 8.

Message Terminal

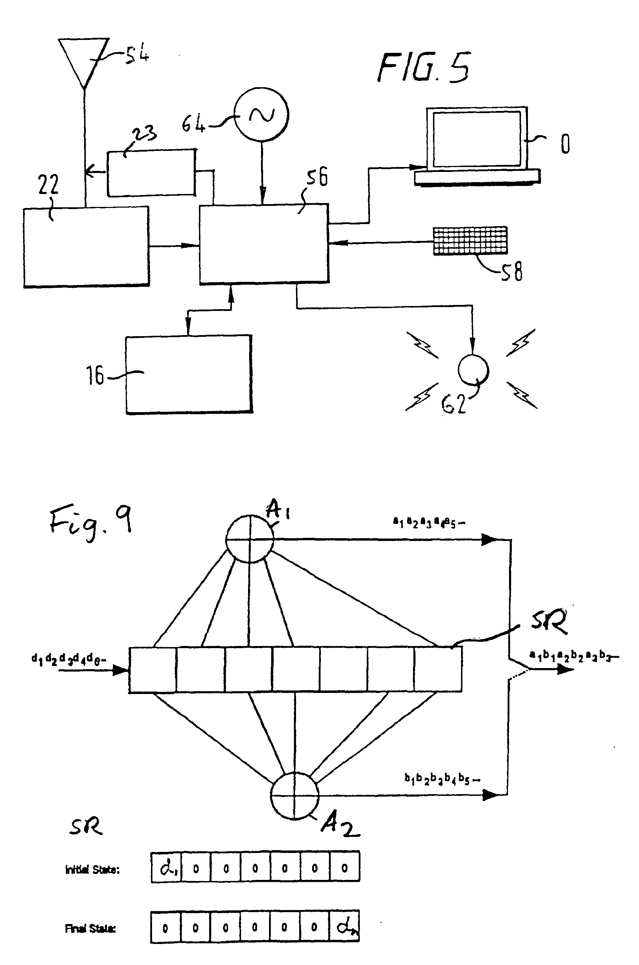

Figure 5 shows the functional portions of the message terminal 14, which comprise an antenna 54 connected to the receiver 22 and to the transmitter 23. A controller 56 receives message data from the receiver 22 and sends acknowledgement signals to the transmitter 23. The controller 56 has a clock 64 which enables tuning of the receiver 22 to a predetermined frequency at a predetermined time and which provides a reference for the transmission timing of acknowledgement signals. Messages addressed to the message terminal 14 are stored in the message terminal store 16 and retrieved therefrom under the control of the controller 56. The controller 56 is connected to a keypad 58 to allow the user to control the terminal 14 and to input short messages for return transmission. Received messages are displayed on a display 40, which may be a liquid crystal display (LCD). The controller 36 is also connected to an alerting device 42 to alert the user 18 when a new message has been received, by generating an audible tone, flashing an LED or by other suitable means. The user 18 may then operate a key on the key pad 38 to actuate display of the new message. Previously received messages may also be displayed.

The terminal 14 may be a simple message receiver/transmitter or may be integrated with other functions, such as in a duplex voice and/or data terminal. For example, an Inmarsat-mM™ terminal may also have Inmarsat-D™ functionality.

Traffic Channel Structure

Each traffic channel T is transmitted at a corresponding traffic channel frequency. The traffic channel transmissions are arranged in a series of constant length frames of data symbols, each data symbol comprising five bits modulated by 32-ary (32 state) orthogonal frequency shift keying (FSK), at a symbol rate of 4 symbols per second. Each frame may have a length FL of 960 symbols, corresponding to 4 minutes' duration, for example. The adjacent frequency spacing of the modulation is 20Hz, giving a frequency range of the carrier frequency ±3 10Hz.

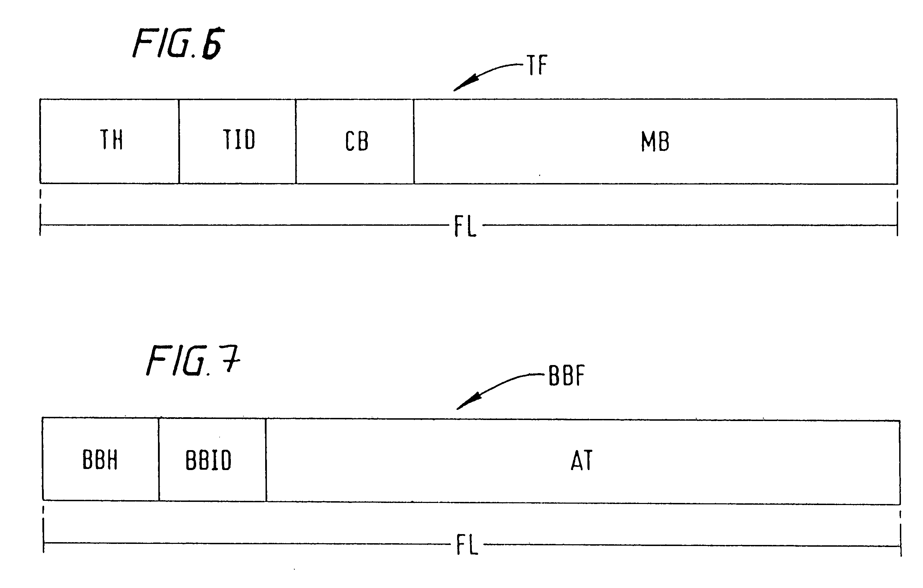

The structure of each traffic frame is shown in Figure 6. The traffic frame TF begins with a frame header TH of fixed length which contains synchronisation information to assist the terminals 14 to acquire the timing and frequency of the traffic channel TF. There follows a frame identity block TID which contains general system information, such as the identity code of the transmitting earth station 8 and the serial number of the frame.

The frame identity block TID includes a return channel control word defined as follows:

Table 1

| Bit No. | Data |
|---------|------|
| 36-41 | Acknowledge Flag Total |
| 42-56 | Base Return Channel |
| 57-59 | Number of Additional Return Channels |
| 60-61 | Return Channel Transmission Timeslot Length |
| 62-63 | Traffic Control |
| 64-65 | Satellite Doppler Value |
| 66-70 | Number of Pre-allocated Return Timeslots |

The definitions of the different data fields are as follows:

Acknowledge flag total: the number of messages in the previous frame in which the acknowledge flag was set;
Base Return Channel: a value identifying the lowest frequency return channel to be used in response to the current traffic frame;
Number of Additional Return Channels: a value indicating the number of additional return channels to be used immediately above the base return channel in frequency.
Return Channel Transmission Timeslot Length: selects the length of each timeslot in the Return Channel, in this example 2.5 or 10 seconds.
Traffic Control: controls the level of usage of the return channel by the terminals.
Satellite Doppler Value: relates to the current level of satellite differential Doppler, and determines the amount of frequency offset applied by terminals when transmitting in the return channel.
Number of Preallocated Return Timeslots: determines how many timeslots are preallocated to time slots in the return channel, as described below.

Next, the frame TF contains a control block CB containing control information, followed by a message block MB containing one or more messages addressed to individual terminals 14. Each message has a message header including a 20-bit forward ID code indicating the terminal 14 to which the message is addressed, a message type code indicating the message type, an acknowledge flag indicating whether an acknowledgement is required, and optionally an acknowledgement RSN, indicating a reserved slot number to be used for acknowledgement in the return channel, as will be described below.

The forward ID code is selected by the earth station 8 according to the pager number dialled by the caller 2 and passed by the service provider 4 to the earth station 8. Each terminal 14 is assigned a unique ID code which is stored in the terminal 14 and the earth station 8 but is not disclosed to the terminal user 18. The ID code may be programmed into the terminal 14 during manufacture or stored on a smart card so that the ID code follows the user 18 rather than the terminal 14. This ID code is transmitted in the forward ID field by the earth station 8.

The header is followed by the message data itself, of variable length, and a message delimiter. The messages are concatenated together in a bitwise fashion, across symbol boundaries. If insufficient messages are available to fill the message block field MB, transmission in the traffic channel ceases at the end of the messages until the beginning of the next frame TF.

Bulletin Board Channel Structure

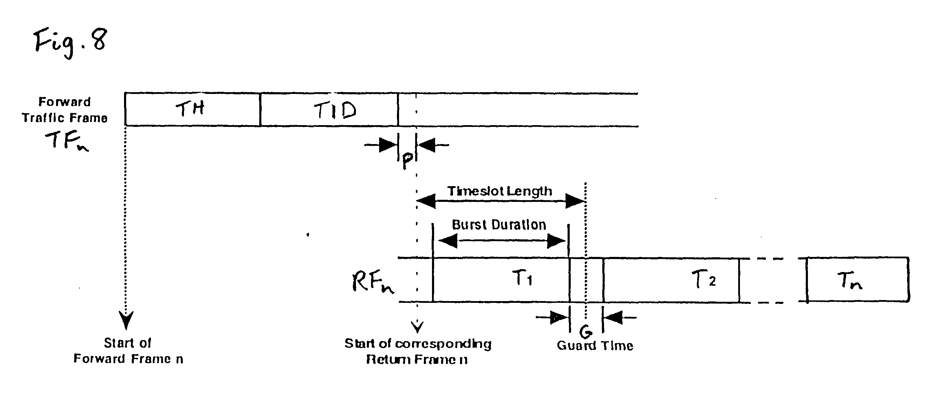

The bulletin board channel is transmitted continuously at a fixed frequency, with the same modulation scheme and frame length as the traffic channel frames TF. As shown in Figure 7, each bulletin board frame BBF comprises a frame header BBH, a bulletin board identity BBID and an allocation table AT.

The frame header BBH comprises synchronisation information to assist terminals in acquiring the bulletin board channel. The bulletin board ID field BBID contains general information such as the identity of the earth station 8 transmitting the bulletin board channel, the date and time, and the version number of the bulletin board, which is changed every time a change occurs in the information transmitted in the allocation table AT.

The allocation table AT comprises a set of entries transmitted sequentially, each relating to one traffic channel. Each entry comprises the following information:

1. A service ID indicating a specific service using the relevant traffic channel. The service corresponds to one specific service provided by one of the service providers 4.

2. A satellite beam ID identifying the satellite beam over which the traffic channel is transmitted.

3. A pager subset number range, indicating the group of terminals 14 allocated to that traffic channel. Each terminal 14 is pre-programmed with the different subsets into which it falls.

4. A channel number, which indicates the frequency assigned to that traffic channel.

Unused entry fields are filled with idle codes, so that the transmission on the bulletin board channel is continuous.

Return Channel Structure

Each return channel may be transmitted either on the global beam of the satellite or on one of the spot beams. The symbol rate varies depending on whether the global beam or one of the spot beams is used. The spacing between adjacent return frequency channels is 2.5 kHz.

Corresponding to each traffic channel T, a set of from 1 to 8 return link channels is allocated, according to the number of additional return channels indicated in the return channel control codeword. The return link channels within a set occupy a contiguous block of channels, leading to the following important advantages:

a) Only the base channel and the number of additional channels need be indicated in the return channel control codeword, occupying $15 + 3 = 18$ bits. If non-contiguous return channels were to be allocated, a total of $8 \times 15 = 120$ bits would be needed;

b) The terminals 14 using the same satellite 12 use the same Bulletin Board channel as a frequency reference. Therefore, no additional guard band is needed between the contiguous return frequency channels, because the terminals using these channels will all be using the same frequency reference.

c) The return channel demodulator 42 can use a single synthesizer and digital signal processing (DSP) unit to demodulate the whole set of return channels using digital sampling/processing techniques, rather than using a separate unit per channel if the channels were allocated independently.

Return channel transmissions are modulated by 2-level frequency shift keying (FSK), with a spacing of 256 kHz between the two frequencies. The symbol rate is 4, 16 or 32 symbol/s for reception in the global beam and 16, 64 or 128 symbol/s for reception in a spot beam, the different rates being selected according to the type of acknowledgement burst, as will be described below.

Transmissions are formatted on the return channel in time-divided frames with a constant timing relationship to the corresponding traffic frame TF, as shown as shown in Figure 8. Corresponding to the $n^{th}$ traffic frame $TF_n$, a return frame $RF_n$ begins a period P, for example 1 second, after the end of the frame identity block TID. The return frame RF comprises a series of time slots $T_1$ to $T_n$ each separated by a guard band G. In a global beam channel, the length of each time slot is 8 seconds and the guard band is 2 seconds, while in a spot beam channel the length is 2 seconds and the guard band is 0.5 seconds. Thus, the number of symbols in each time slot is constant for a particular type of return channel, but the length varies according to the symbol rate.

In each return channel frame RF, the earth station 8 allocates each Return Slot S, defined by the time slot T and return channel number C, as either Reserved, Unreserved or Preallocated.

First, the Return Slots S are allocated Return Slot Numbers RSN such that:

$$RSN = (A + 1) * (n - 1) + (C - B + 1)$$

where A is the number of Additional Return Channels
n is the time index of the current slot (1 to 12, 24, 48 or 96 depending on the number of timeslots per frame)
B is the Base Return Channel number
C is the Return Channel number of the current slot

In summary, the timeslots are numbered primarily by Return Channel number and secondarily by time index. In the example below, A = 4, B = 3, and there are 96 timeslots per frame.

Table 2 -

| RSN | | | | | |
| --- | --- | --- | --- | --- | --- |
| C/n | 1 | 2 | 3 | 4... | 96 |
| 7 | 5 | 10 | 15 | 20 | 480 |
| 6 | 4 | 9 | 14 | 19 | 479 |
| 5 | 3 | 8 | 13 | 18 | 478 |
| 4 | 2 | 7 | 12 | 17 | 477 |
| 3 | 1 | 6 | 11 | 16 | 476 |

The allocation of slots is divided according to time index n, but not Return Channel number C; thus, in any one time slot $T_n$, return slots S in each Return Channel frequency are allocated to the same category.

Reserved Return Slots

Reserved Return Slots $S_{RES}$ are used for acknowledgement bursts only. The number $NT_{RES}$ of reserved time slots T and the number $NS_{RES}$ of reserved Return Slots S is derived from the Acknowledge flag total and Number of additional return channels indicated in the return channel control word of the corresponding traffic frame TF, as follows:

$$NT_{RES} = INT\left[\frac{F-1}{A+1}\right] + 1$$

$$NS_{RES} = NT_{RES} \cdot (A + 1)$$

where F is the Acknowledge Flag total
INT denotes the integer part of the square bracket

The return slot numbers RSN of the reserved return slots $S_{RES}$ are in the range 1 to $NS_{RES}$.

Unreserved Return Slots

Unreserved return slots $S_U$ are used for contention-based transmissions by the terminals, and are allocated in the middle of the return frame RF, after the reserved return slots $S_U$ but before the preallocated return slots $S_{PRE}$. The number $NS_U$ of unreserved return slots $S_U$ is calculated as follows:

$$NS_U = NT_F \cdot (A + 1) - (NS_{RES} + NS_{PRE})$$

where $NT_F$ is the number of time slots T per frame
$NS_{PRE}$ is the number of preallocated return slots $S_{PRE}$

The reserved slot numbers RSN of unreserved return slots are in the range $NS_{RES} + 1$ to $NT_F \cdot (A + 1) - NS_{PRE}$.

Preallocated Return Slots

Preallocated return slots $S_{PRE}$ are used for data reporting services and are located at the end of the return channel frame RF. The number $NS_{PRE}$ of preallocated return slots $S_{PRE}$ is set in the return channel control word of the corresponding traffic frame, as described above. The reserved slot numbers RSN of the preallocated return slots $S_{PRE}$ are in the range $NT_F.(A + 1) - NS_{PRE} + 1$ to $NT_F.(A + 1)$.

Protocol for Reserved Return Slots

If a terminal 14 receives a message in a traffic frame TF, with the acknowledge flag set and with a forward ID code matching the ID code of the terminal, and the terminal successfully decodes the message and the frame identity block TID, the terminal transmits an acknowledge burst in the return channel frame RF immediately following the end of that traffic frame TF, i.e. in the return channel frame RF which follows the frame identity block TID of the traffic frame following the traffic frame in which the message was sent.

In one alternative, the terminal transmits the acknowledge burst in the return slot S corresponding to the acknowledgement RSN in the message header of the message being acknowledged.

In another alternative, no acknowledgement RSN is included in the message header. Instead, the terminal decodes the message headers of all the messages transmitted in a message block and counts the number N of message headers having the acknowledgement flag set transmitted before the message addressed to that terminal. The terminal then determines its own return slot number as N+1. For example, if the terminal decodes 6 message headers addressed to other terminals before receiving a message header addressed to itself, and 3 of those headers have the acknowledgement flag set, the terminal transmits the acknowledgement burst in return slot number 4. An advantage of this method over the alternative is that no explicit reservation information is sent, thereby reducing the signalling overhead in the message header. A disadvantage is that the terminal must successfully decode all of the message headers preceding its own in order to determine its reserved slot number.

Protocol for Unreserved Return Slots

The terminals 14 use unreserved return slots $S_U$ for sending messages to the earth station 8, independently of acknowledgement of messages sent from the earth station 8. Such messages may be from data logging terminals which have not been preallocated any slots, or a message entered by a user.

If a message is input to the terminal 14 before the terminal has acquired a traffic frame TF, the terminal 14 waits until it decodes a frame identity block TID from which the frame timing and return slot allocation can be determined. The terminal 14 then transmits in a randomly selected one of the unreserved slots $S_U$.

Alternatively, if the terminal 14 has already acquired the traffic channel when a message is input, the terminal selects an unreserved return slot $S_U$ for transmission of the message according to the timing of the input of the message relative to a time window, in order to minimize the delay before the message is transmitted, while taking advantage of the random timing of the input relative to the frame timing, so as to spread the transmissions from different terminals 14 throughout the unreserved return slots $S_U$.

The earth station 8 acknowledges receipt of messages in unreserved slots $S_U$ by sending a message to the relevant terminal 14 in one of the traffic channels.

Frequency Randomization

Each return channel frequency is assigned a nominal value, with a channel spacing of 2.5 kHz in L band. However, the bandwidth of return channel signals is very much less than the channel spacing, with a spacing of only 256 kHz between the two frequency symbols. This channel spacing is necessary to prevent inter-channel interference due to differential Doppler in transmissions from different terminals 14.

When using unreserved return slots $S_U$, two or more terminals 14 may select the same slot for transmission. If there is no differential Doppler between the terminals, and no offset in their transmission frequencies, the transmissions will interfere and neither can be demodulated by the earth station 8. However, if there is differential Doppler due to the difference in direction of the terminals 14 from the satellite 12, this may separate the transmissions in frequency sufficiently for the transmissions to be decoded by the earth station.

In order to increase the chance of the earth station 8 decoding different transmissions in the same unreserved return slot $S_U$, the terminals 14 add a random frequency offset to the nominal return channel frequency, within the ranges shown below:

Table 3 -

| Range of Frequency Offset (±Hz) | | |
|---|---|---|
| **Satellite Doppler** | **Fixed Application** | **Mobile Application** |
| 0 | 980 | 590 |
| 1 | 840 | 450 |
| 2 | 530 | 140 |
| 3 0 0 | | |

The 'Satellite Doppler' value is that set in the return channel codeword, and is an indication of the maximum differential Doppler. The earth station 8 calculates the value according to the orbital inclination of the satellite 12, and the geographical spread of the beam in which the relevant traffic channel is transmitted. The maximum differential Doppler is higher for the global beam than for the spot beams. The Doppler ranges corresponding to the Satellite Doppler values are shown below:

Table 4

| **Modulus of Doppler /Hz** | **Satellite Doppler Value** |
|---|---|
| 0-30 | 0 |
| 30 - 100 | 1 |
| 100-300 | 2 |
| >300 | 3 |

The frequency offset range is reduced for mobile applications, to compensate for Doppler due to the velocity of the terminal 14 relative to the earth's surface, thereby ensuring that the combined effect of frequency offset, satellite Doppler and terminal Doppler cannot cause interference with neighbouring channels.

In summary, a combination of random frequency offset at the transmitter 23 of the terminal 14 and the differential Satellite Doppler spreads the transmissions randomly across the available channel bandwidth, with the random frequency offset being controlled according to the maximum differential Doppler so as to avoid transmitting out of band, while minimizing the chance of interference between transmissions in the same return slot S.

Acknowledge Burst

The messages transmitted by the terminals 14 in the return slots are either a simple acknowledgement burst or a long or short data burst. The acknowledgement burst consists of a sequence of 32 bits derived from a 20-bit return ID code identifying the transmitting terminal 14, as follows:

P1' P1 P2 P2' P3 P4 P4' P5 P6 P6' P7 P8 P8' P9 P10 P10' P11 P11' P12 P13 P13' P14 P15 P15' P16 P17 P17' P18 P19 P19' P20 P20'

where Px denotes bit x of the return ID code and Px' is that bit inverted.

The return ID code is not the same as the forward ID code transmitted in the message header, but is derived from the forward ID code by an algorithm stored in the terminal 14 and the earth station 8. This makes it more difficult for an eavesdropper to match forward and return traffic from a specific terminal. The same algorithm may be used for all terminals 14, so that the earth station does not need to store a separate algorithm for each terminal. The algorithm is not made known to the user 18.

Thus, when the earth station 8 receives an acknowledgement burst including a return ID code, there is no need to compare the return ID code with a separate set of return ID codes to determine which terminal 14 transmitted the acknowledgement burst. Instead, the earth station 8 applies the algorithm to the return ID code to generate the corresponding forward ID code, compares the forward ID code with a database of forward ID codes stored at the earth station 8, and, when a match is found, determines the identity of the terminal 14 from the database. Information relating to the identity of the terminal may then be passed to the return call recording system 44, the forward link interface 48 or the terrestrial interface 50.

The terminal may store its return ID code instead of the algorithm scrambling vector, with the return ID code being calculated from the forward ID code at the time of programming the ID codes into the terminal or smart card. This prevents the algorithm from being discovered by reverse engineering of the terminal or smart card, and used to derive return ID codes for other terminals.

The algorithm may be an exclusive-OR operation with a scrambling vector, or any sequence of operations such as barrel shifting or bit-swapping which provide a one-to-one relationship between forward and return ID codes.

Data Bursts

If the terminal 14 has data to send to the earth station 8, this is transmitted in either long or short data bursts. The data bursts each comprise the return ID code, a destination address, an indication of whether a response is required from the earth station 8, and user data. The total length of the short data burst is 64 bits and of the long data burst, 128 bits.

The data burst is formatted, scrambled with a scrambling vector, error correction coded and interleaved before being modulated. The structure of the error correction convolutional coder is shown in Figure 9. The convolutional coder consists of a 7-bit shift register SR and two binary adders $A_1$ and $A_2$ having as inputs respectively positions 1 to 4 and 7, and positions 1, 3, 4, 6 and 7 of the shift register. The outputs of the binary adders $A_1$ and $A_2$ are binary with no carry bits. The initial state of the shift register SR has the first input bit $d_1$ in the first position and zeroes in the other positions, while the final state of the shift register has the last bit $d_n$ in the last position and zeroes in the other positions. The input bits $d_1...d_n$ produce two output bit sequences $a_1...a_n$ and $b_1...b_n$ from the binary adders $A_1$ and $A_2$ respectively, giving a half rate code.

The output sequences are read into an interleaving matrix of 8 x 16 for the short data burst and 16 x 16 for the long data burst. The order of the short data burst interleaving matrix is shown below:

Table 5

| $a_1$ | $b_1$ | $a_2$ | $b_2$ | $a_3$ | $b_3$ | $a_4$ | $b_4$ |
|---|---|---|---|---|---|---|---|
| $b_5$ | $a_5$ | $b_6$ | $a_6$ | $b_7$ | $a_7$ | $b_8$ | $a_8$ |
| $a_9$ | $b_9$ | $a_{10}$ | $b_{10}$ | $a_{11}$ | $b_{11}$ | $a_{12}$ | $b_{12}$ |
| . | . | . | . | . | . | . | . |
| . | . | . | . | . | . | . | . |
| $b_{61}$ | $a_{61}$ | $b_{62}$ | $a_{62}$ | $b_{63}$ | $a_{63}$ | $b_{64}$ | $a_{64}$ |

The bits are read out of the interleaver column by column, so that the output sequence is:

$a_1b_5a_9...b_{61}b_1a_5b_9...a_{61}a_2b_6a_{10}...$ etc.

The order of reading *a* and *b* bits into the interleaver is reversed in alternate rows, so that the output sequence contains alternating *a* and *b* bits, except when moving from one column to the next. In the event of a burst error in the transmitted sequence, the number of corrupted *a* bits will be approximately the same as the number of corrupted *b* bits. This reduces the bit error rate in simulated channel conditions using a Viterbi decoder, relative to an arrangement in which the bits are read into the decoder with *a* and *b* bits in the same order in each row, such that the output sequence consists of alternating sequences of 8 *a* bits and 8 *b* bits.

Aspects of the present invention are applicable to satellite communications systems using satellites other than geostationary satellites, in which case the allocation of earth stations to satellites will change as the satellites come into or go out of view of different earth stations.

It will be appreciated that individual elements of a messaging or paging system may be located in different jurisdictions or in space. The present invention extends to any such element which contributes to the aspects of the invention as herein defined.

**Claims**

1. A transmission encoder for encoding data prior to radio frequency transmission, the encoder comprising:

a data input for receiving said data in binary form;
a convolutional encoder for convolutionally encoding said binary data to generate first and second binary encoded sequences, said first and second binary encoded sequences being generated by different convolutional encoding algorithms; and
an interleaver for receiving said first and second binary encoded sequences and for outputting said first and second binary encoded sequences in an interleaved sequence; wherein said interleaved sequence comprises sequences of bits alternately from said first and second binary encoded sequences.

2. A transmission encoder as claimed in claim 1, wherein said interleaver is representable by a two-dimensional array into which alternating bits from the first and second binary encoded sequences are read along a first dimension of said array, with different said alternating sequences being separated along a second dimension of said array, and the interleaved sequence comprises sub-sequences each generated by reading sequentially from said array along said second dimension, with different sub-sequences being separated along said first dimension, wherein each said sub-sequence comprises alternating bits from the first and second binary encoded sequences.

3. A transmitter comprising a transmission encoder as claimed in claim 1 or 2, and a modulator for modulating a radio frequency carrier with said interleaved sequence of bits.

4. A method of encoding data, comprising:

    receiving said data in binary form;
    convolutionally encoding said binary data to generate first and second binary encoded sequences, said first and second binary encoded sequences being generated by different convolutional encoding algorithms; and interleaving said first and second binary encoded sequences so as to output said first and second binary encoded sequences in an interleaved sequence; wherein said interleaved sequence comprises sequences of bits alternately from said first and second binary encoded sequences.

5. A method as claimed in claim 4, wherein said interleaving step is representable by reading sequences of bits alternately from the first and second binary encoded sequences into a two-dimensional array along a first dimension, with different said sequences of alternate bits being separated along a second dimension of said array, and by reading sub-sequences of said interleaved sequence sequentially from said array along said second dimension, with different sub-sequences being separated along said first dimension, wherein each said sub-sequence comprises alternating bits from the first and second binary encoded sequences.

6. A method of addressing a plurality of messaging terminals in a radio frequency messaging system, comprising:

    receiving a plurality of messages and a corresponding plurality of terminal addresses indicating for which of said terminals said messages are addressed;
    determining a plurality of forward identity codes each corresponding to one of said terminals to which said messages are addressed;
    transmitting said messages and said identity codes to said terminals;
    receiving response signals from said terminals, each said response signal including a return identity code;
    decoding each said return identity code by applying a predetermined algorithm thereto to generate a corresponding forward identity code; and
    comparing said transmitted forward identity codes with said received forward identity codes so as to determine which of said terminals have responded to said messages.

7. A method of operating a plurality of messaging terminals in a radio frequency messaging system, comprising, at each said terminal:

    storing a terminal identity code;
    receiving a plurality of messages and a corresponding plurality of address codes;
    decoding said address codes;
    comparing each of said address codes with said terminal identity code;
    and, if one of said address codes matches said terminal identity code, transmitting a response signal including a return identity code;

    wherein, for each of said terminals, said corresponding return identity code is related to said terminal identity code by the same algorithm.

FIG.1

Caller

Satellite — 12

Service Provider — 4

Earth Station — 8

Terminal — 14

User — 18

Caller — 2

Message store — 6

Message store — 10

Message store — 16

1st STAGE | 2nd STAGE | 3rd STAGE

EP 1 420 518 A2

FIG. 2

EP 1 420 518 A2

Fig. 3

12

| Modulator(s) | Modulator | |
|---|---|---|
| Traffic Modulator 30 | Bulletin Board Modulator 36 | Paging System Control Unit (PSCU) 34 |

Message Processor 26

Paging Traffic

Terrestrial Interface 24

Service Providers

File Exchange Facility 32

NMS

Fig. 4

C-Band Downlink IF

Return Channel Demod. Unit 42

Return Channel Control Unit 40

Forward Link Interface 48 34

(Optional)

Return Call Recording System 44

Operator Interface 46

NMS 20

Terrestrial Interface 50

Service Provider

FIG. 5

Fig. 9

*FIG.6*

| TH | TID | CB | MB |
|----|-----|----|----|

TF

FL

*FIG.7*

| BBH | BBID | AT |
|-----|------|-----|

BBF

FL

Fig. 8

Forward
Traffic Frame
$TF_n$

| TH | TID | |
|---|---|---|

P

Timeslot Length

Burst Duration

$RF_n$

| $T_1$ | $T_2$ | $T_n$ |

G

Start of
Forward Frame n

Start of corresponding
Return Frame n

Guard Time

EP 1 420 518 A2